# EUROPÄISCHE PATENTSCHRIFT

(11) **EP 1 470 263 B1**
(45) Veröffentlichungstag und Bekanntmachung des Hinweises auf die Patenterteilung: **09.09.2009**
(21) Anmeldenummer: 03718664.0
(22) Anmeldetag: 28.01.2003
(51) Int. Cl.: C23C 14/06

(54) **VERFAHREN ZUR ABSCHEIDUNG VON METALLFREIEN KOHLENSTOFFSCHICHTEN**
METHOD FOR DEPOSITING METAL-FREE CARBON LAYERS
PROCEDE DE DEPOT DE COUCHES DE CARBONE DEPOURVUES DE METAL

(30) Priorität: 30.01.2002 DE 10203730
(43) Veröffentlichungstag der Anmeldung: 27.10.2004
(73) Patentinhaber: Fraunhofer-Gesellschaft zur Förderung der angewandten Forschung e.V., 80686 München (DE)
(72) Erfinder: BEWILOGUA, Klaus, 38110 Braunschweig (DE); WITTORF, Ralf, 38176 Wendeburg (DE); THOMSEN, Helge, 38118 Braunschweig (DE)
(74) Vertreter: Einsel, Martin
(86) Internationale Anmeldenummer: PCT/EP2003/000844
(87) Internationale Veröffentlichungsnummer: WO 2003/064720

(56) Entgegenhaltungen:
- EP-A- 1 067 211
- WO-A-00/55385
- WO-A-99/27893
- US-A- 6 086 730
- CHARRIER C ET AL: "CARBON FILMS DEPOSITED BY THE PHYSICAL VAPOUR DEPOSITION FOCUSED-ARC EVAPORATION TECHNIQUE" DIAMOND AND RELATED MATERIALS, ELSEVIER SCIENCE PUBLISHERS, AMSTERDAM, NL, Bd. 3, Nr. 1/2, 1994, Seiten 41-46, XP000415316 ISSN: 0925-9635
- ANDERS S ET AL: "MECHANICAL PROPERTIES OF AMORPHOUS HARD CARBON FILMS PREPARED BY CATHODIC ARC DEPOSITION" MATERIALS RESEARCH SOCIETY SYMPOSIUM PROCEEDINGS, MATERIALS RESEARCH SOCIETY, PITTSBURG, PA, US, Bd. 383, 17. April 1995 (1995-04-17), Seiten 453-458, XP000677135 ISSN: 0272-9172

## Beschreibung

Die Erfindung betrifft ein Verfahren zur Abscheidung von metallfreien amorphen wasserstoffhaltigen Kohlenstoffschichten durch Sputtern von Targets auf Substrate.

Für viele Anweridungsfälle ist es interessant, relativ dünne Kohlenstoffschichten auf Substraten abzuscheiden. Dabei geht es insbesondere um Schichten aus hartem und verschleißfestem diamantähnlichen Kohlenstoff, wobei diese Schichten auch als DLC (diamond like carbon)- Schichten oder auch a-C:H-Schichten bezeichnet werden. Diese Schichten enthalten neben Kohlenstoff auch Wasserstoff mit einer Konzentration zwischen 10 und 30 Atomprozent, Metallanteile in weniger als 0,1 Atomprozent und andere Verunreinigungen (beispielsweise Sauerstoff, Stickstoff, Argon) mit einer Gesamtkonzentration von weniger als 3 Atomprozent.

Zur Abscheidung dieser harten amorphen wasserstoffhaltigen Kohlenstoffschichten (DLC beziehungsweise a-C:H) und zu ihren Eigenschaften gibt es zahlreiche Publikationen. Derartige Schichten weisen neben sehr niedrigen Reibwerten gegenüber Stahl (< 0,2) eine hohe Härte- und Verschleißbeständigkeit auf. Die DLC-Schichten sind in der Regel chemisch inert, elektrisch isolierend mit spezifischen Widerständen von mehr als 10⁶ Ohmzentimenter und sie sind im infraroten Spektralbereich transparent.

Qualitativ hochwertige a-C:H-Schichten, insbesondere qualitativ hochwertig hinsichtlich Härte und Verschleiß, werden heute vorwiegend noch in relativ kleinen Anlagen mittels plasmaaktivierter Gasphasenabscheidung (plasma activated chemical vapour deposition, kurz PACVD) hergestellt. Dabei werden überwiegend Hochfrequenztechniken mit Frequenzen von mehr als einem Megahertz (MHz) eingesetzt, in der Regel 13,56 MHz. Dabei ist die plasmaerzeugende Elektrode gleichzeitig das zu beschichtende Substrat. Als Kohlenstoffquelle werden dabei Kohlenwasserstoffe, vorzugsweise Acetylen (C₂H₂) oder Methan (CH₄), eingesetzt. Die Schichten entstehen durch Abscheidung von Ionen und Radikalen aus einer Glimmentladung auf einem ungeheizten Substrat.

Sehr nachteilig ist es, dass diese Hochfrequenzverfahren zur DLC-Abscheidung nur schwer hochskaliert werden können. Es wird eine negative Self-Bias-Spannung U_{B} von einigen 100 Volt benötigt. Diese Spannung U_{B} hängt aber stark vom Verhältnis der Flächen der Substratelektrode zur Anode ab. Als Anode wird in der Regel das geerdete Gehäuse der Anlage verwendet. U_{B} sinkt dabei mit zunehmender Größe der Substratelektrode erheblich ab. Eine größere Substratfläche erfordert außerdem leistungsstärkere Hochfrequenzgeneratoren, um etwa konstante Leistungsdichten am Substrat noch aufrechtzuerhalten. Derartige leistungsstarke Hochfrequenzgeneratoren sind allerdings sehr teuer und reduzieren damit die Wirtschaftlichkeit derartiger Verfahren.

Um dieses Problem zu umgehen, ist daher schon vorgeschlagen worden, stattdessen den Mittelfrequenzbereich zwischen einem und einigen hundert kHz zur Abscheidung von a-C:H-Schichten zu nutzen. Die DE 195 13 614 C1 und andere haben dabei sowohl harmonische Wechselspannungen als auch gepulste Gleichspannungen vorgeschlagen. Auch hier handelt es sich aber meist um PACVD-Verfahren, bei denen wiederum die Substratelektrode gleichzeitig die plasmaerzeugende Elektrode ist. Dadurch ist es nicht möglich, Beschichtungsparameter wie beispielsweise den Ionenstrom und die Ionenenergie, unabhängig voneinander einzustellen. Auch hier sind daher wirtschaftlichen Einsätzen derartiger Verfahren Grenzen gesetzt.

Ähnliche Probleme bestehen bei Konzeptionen etwa nach der DE 196 51 615 C1, in der ein PVD-Verfahren vorgeschlagen wird. Dort wird am Target mit mittelfrequenter Spannung gearbeitet, um einen reaktiven Sputterprozess zu erhalten.

S. Fujimaki, H. Kashiwase und Y. Kokaku haben in "New DLC coating method using magnetron plasma in an unbalanced magnetic field" in: Vacuum 59 (2000), Seiten 657 bis 664 eine modifizierte Vorgehensweise angeregt, die sie als Plasma Enhanced Chemical Vapor Deposition (PE-CVD) bezeichnen. Zum Beschichten von Magnetspeicherplatten werden diese nahe am Target und in der Entladungszone des Targets als ebene Substrate in einen Bereich hoher Plasmadichte eingebracht. Der Abstand des Substrats vom Target bzw. der Kathode beträgt 40 mm und bleibt während der Beschichtung konstant, da alle Elemente zueinander in einer festen, unbeweglichen Position stehen. Eine unbalancierte Magnetronkathode am Target liefert die Plasmaunterstützung. Am Substrat liegt eine gepulste Gleichspannung (DC) an, um Substrataufladungen zu vermeiden. Es entstehen sehr dünne (15 nm) und polymerartige Schichten mit hohem spezifischem Widerstand, aber relativ niedriger Härte von weniger als 15 GPa. Die extrem geringe Schichtdicke und die niedrige Härte sind für viele Anwendungsfälle nicht ausreichend.

Ältere, beispielsweise aus der US-PS 4,597,844 bekannte Vorschläge zur Abscheidung von amorphen Kohlenstoff und Wasserstoff enthaltenden Schichten verwenden Graphittargets und nur Wasserstoff und/oder Fluor enthaltende Reaktivgase. Dies führt zu polymerartigen Schichten mit sehr hohen spezifischen Widerständen von mehr als 10⁸ Ohmzentimetern und einem Wasserstoffgehalt in den Schichten von 0,5 bis 0,9, gemessen am Verhältnis von der Zahl der Wasserstoffatome zur Zahl der Kohlenstoffatome (H/C). Diese Schichten entsprechen nicht mehr den gestiegenen Anforderungen.

Von daher sind gänzlich andere Ansätze zur Erzielung von Kohlenstoffschichten mit den geeigneten Eigenschaften getätigt worden. So sind metallhaltige Kohlenstoffschichten vorgeschlagen worden, erstmals in der EP 0 087 836 B1. Derartige, meist als Me-C:H oder Me-DLC bezeichnete Schichten werden in industrierelevanten Dimensionen in Vakuumbeschichtungsverfahren hergestellt, und war durch Zerstäuben (Sputtern) einer Festkörperoberfläche (eines Targets) durch Beschuss mit energiereichen Ionen. Als Targetmaterialien dienen üblicherweise Carbid-bildende Metalle wie Titan, Niob, Chrom, Wolfram oder auch Carbide wie Wolframcarbid. Ein Nachteil derartiger Schichten ist allerdings, dass ihre niedrigsten Verschleißraten, gemessen mit einem Kalotten-Tester, zwischen etwa 2 und 5 VE liegen, also wesentlich schlechter sind, als die von harten a-C:H-Schichten, die etwa zwischen 0,5 und 1 VE betragen. 1 VE ist eine Verschleißeinheit und entspricht 10⁻¹⁵ m³/Nm.

Es ist daher versucht worden, den Metallanteil in derartigen Schichten zu reduzieren, indem die metallischen Targets durch eine modifizierte Prozessführung weitgehend mit Kohlenstoff bedeckt werden, was als "Vergiftung" bezeichnet wird. Derartige Verfahren sind aber schwer zu beherrschen, da die Entladungsprozesse sehr instabil werden und nicht über längere Zeiten aufrecht zu erhalten sind.

Als weiterer Ansatz wird daher von Da-Yung Wang, Chi-Lung Chang und Wei-Yu Ho in "Characterisation of hydrogen-free diamond-like carbon films deposited by pulsed plasma technology" in: Thin Solid Films 355 bis 356 (1999), Seiten 246 bis 251 ein Beschichtungsverfahren für eine titandotierte, also metallhaltige, dafür aber wasserstofffreie Schicht vorgeschlagen. Die Autoren führen die mangelnde Härte bekannter Schichten auf das Vorhandensein von Wasserstoffatomen zurück. Sowohl die verwendeten Graphit- als auch die Titantargets und das Substrat werden jeweils mit gepulsten Mittelfrequenz-Gleichspannungen (DC) versorgt. Die entstehenden Schichten unterscheiden sich natürlich deutlich von wasserstoffhaltigen Beschichtungen.

Es besteht daher unverändert der Wunsch, metallfreie Kohlenstoffschichten abzuscheiden, um die Nachteile der Me-C:H-Schichten nicht in Kauf nehmen zu müssen. Gewünscht wäre ein Verfahren zur Abscheidung einer derartigen metallfreien Kohlenstoffschicht, das auch in größerem Maßstab und wirtschaftlich eingesetzt werden kann.

Aufgabe der Erfindung ist es daher, ein derartiges Verfahren vorzuschlagen:

Diese Aufgabe wird dadurch gelöst, dass von Targets auf die Substrate gesputtert oder mittels Bogenverdampfung abgeschieden wird, dass die Targets mit einer negativen Gleichspannung vorgespannt werden, dass als Target ein reines Kohlenstoff-Target eingesetzt wird, dass das Substrat mit einer negativen Spannung vorgespannt ist, und dass eine Ionenstromdichte von mindestens 1 mA/cm² am Substrat erreicht wird.

Überraschenderweise zeigte sich, dass bei einem derartigen Verfahren die von herkömmlich hergestellten a-C:H beziehungsweise DLC-Schichten bekannten Verschleiß- und Härtewerte erreicht und zum Teil noch übertroffen werden können. Bisher war es nicht für möglich gehalten worden, mit einem reinen Gleichstrom-Sputter-Verfahren derartige Werte erreichen zu können, also ohne den Einsatz von Hochfrequenz- oder wenigstens Mittelfrequenz-Verfahren. Nur bei den in der Qualität schlechteren und ganz anders aufgebauten Me-C:H-Schichten wurde bisher ein Sputtern als sinnvoll gesehen, für a-C:H-Schichten sind nur Entladungen von Kohlenstoffplasmen in Betracht gezogen worden.

Darüber hinaus entstehen Schichten mit Härten von mehr als 30Gpa und von 1 µm bis zu mehreren Mikrometern Dicke, also mit mehr als etwa bei dem Verfahren von Fujimaki et al.

Zu unterscheiden ist dabei noch zwischen der negativen Vorspannung am Target und der negativen Vorspannung am Substrat. Die negative Vorspannung am Target selbst ist erfindungsgemäß eine negative Gleichspannung. Die negative Vorspannung am Substrat kann und ist in einer bevorzugten Ausführungsform auch wirklich eine ebenfalls negative Gleichspannung.

Es ist aber in einer anderen Ausführungsform auch möglich, die negative Vorspannung am Substrat mit einer Mittelfrequenzspannung zwischen 30 und 300 kHz anzuregen. Es wird dann unverändert vom Target mit Gleichstrom gesputtert, da dort eine negative Gleichspannung anliegt, im Gegensatz etwa zur DE 196 51 615 C1.

In der DE 100 18 143 A1 wird zwar mit einer Mittelfrequenz am Substrat gearbeitet, dort aber findet kein Sputtern von einem Target statt.

Bevorzugt ist der Abstand des Substrats vom Target größer als die Entladungszone des Targets. Dadurch kann verhindert werden, dass während der Beschichtung die in der Entladungszone des Targets häufig herrschende hohe Plasmadichte dazu führt, dass eine Art Plasma unterstütztes CVD-Verfahren mit durchgeführt wird und zu polymerartigen Effekten in den abgeschiedenen Kohlenwasserstoffschichten beiträgt. Durch das Vermeiden dieser Effekte wird die Härte der Schichten zusätzlich unterstützt.

Dabei haben sich Abstände der Substrate vom Target von mehr als 50 mm, insbesondere von mehr als 100 mm und besonders bevorzugt von 200 mm und mehr als günstig herausgestellt.

Als Kohlenstoff-Target wird bevorzugt ein reines Graphit-Target eingesetzt, da sich dieses Material besonders bewährt hat. In bestimmten Anwendungsfällen ist aber auch Glaskohlenstöff von Vorteil.

Dabei lassen sich die besten Werte erreichen, wenn in der unbalancierten Magnetron-Betriebsart gearbeitet wird. Dadurch werden in einem Substrat wesentlich höhere Ionenstromdichten realisiert, als im balancierten, konventionellen Magnetronbetrieb. Diese Ionenstromdichten haben sich als erforderlich herausgestellt, um die harte DLC-Modifikation abzuscheiden.

Das erfindungsgemäße Verfahren zur Abscheidung lässt sich relativ einfach hochskalieren, ebenso wie das Verfahren, mit dem sonst Me-DLC-Schichten, also deutlich schlechtere Schichten, hochskalierbar sind.

Bei dem erfindungsgemäßen Verfahren handelt es sich um ein reines Gleichstromverfahren. Dadurch werden keine kostenintensiven Hochfrequenz (HF-) oder Mittelfrequenz (MF-) Stromversorgungen benötigt und es gibt auch keine schwer beherrschbaren Plasmazustände, also auch keine Entladungen an unerwünschten Orten in der Beschichtungskammer, die bei Mittenfrequenz und Hochfrequenz gelegentlich auftreten.

Erfindungsgemäß lässt sich zuverlässiger, kostengünstiger und auch mit geringerem apparativem Aufwand eine Beschichtungsqualität erreichen, die der herkömmlichen mit viel größerem Aufwand erzielbaren ohne weiteres vergleichbar ist und sich auch auf deutlich größere Substratflächen anwenden lässt.

Von besonderem Vorteil ist es auch, dass das erfindungsgemäße Verfahren zur Abscheidung von metallfreien Kohlenstoffschichten auch in eine PVD-(physical vapour deposition) Beschichtungsanlage integriert werden kann. Dadurch wird es besonders einfach möglich, die für eine optimale Haftung sinnvoll erscheinenden Zwischenschichten aus Übergangsmetallen wie Titan, Niob oder Chrom zunächst abzuscheiden, bevor dann die eigentlich gewünschte metallfreie Kohlenstoffschicht über dieser Zwischenschicht abgeschieden wird.

Das erfindungsgemäße Beschichtungsverfahren ist außerordentlich flexibel. Bei Verwendung mehrerer Targets können mit einer für das Verfahren geeigneten Anlage sogar wahlweise DLC oder Me-DLC-Schichten abgeschieden werden, auch in Multilagen.

Außerdem lassen sich Kombinationen von zum Beispiel DLC-und Kohlenstoffnitridschichten (CNₓ-Schichten) herstellen. Hierzu wird beispielsweise am Ende des Beschichtungsvorganges das Kohlenwasserstoffreaktivgas durch Stickstoff ersetzt. Eine solche Schicht ist zum Beispiel sinnvoll, wenn harte und außerdem gut benetzende Schichten benötigt werden. CNₓ (X bis 0,2) weist eine deutlich höhere Oberflächenenergie und damit eine bessere Benetzung als DLC auf.

Als Reaktionsgas hat sich eine Mischung aus einem oder mehreren Edelgasen und einem oder mehreren Kohlenwasserstoffen bewährt. Besonders bevorzugt ist eine Mischung aus Argon und Acetylen.

Zur Haftungsverbesserung können erfindungsgemäß beispielsweise Zwischenschichten abgeschieden werden, die aus Metallen, Metallnitriden, Metallcarbiden, Metallcarbonitriden oder auch aus Mehrlagenanordnungen aus diesen Komponenten bestehen. Besonders bevorzugt ist dabei ein Dickenbereich zwischen 0,02 und 2 µm.

Bevorzugt wird außerdem eine Deckschicht abgeschieden, die ausschließlich Kohlenstoff und Wasserstoff und/oder Stickstoff und weniger als 0,1 % Metallverunreinigungen enthält.

In einer Ausführungsform der Erfindung wird das Reaktivgas während des Beschichtungsvorganges mit zusätzlichen gas- oder dampfförmigen Verbindungen sowie mit Stickstoff und/oder Sauerstoff gemischt oder durch Stickstoff ersetzt.

Dabei ist es bevorzugt, wenn die zusätzlichen gas- oder dampfförmigen Verbindungen Silizium enthalten oder wenn die zusätzlichen gas- oder dampfförmigen Verbindungen Tetramethylsilan (TMS) enthalten oder wenn die zusätzlichen gas- oder dampfförmigen Verbindungen Hexamethyldisiloxan (HMDSO) enthalten. Silizium ist kein Metall, wenn es auch metallische Eigenschaften hat. Der Einbau von Silizium in die gewünschten Schichten ist mit diesen zusätzlichen gas- oder dampfförmigen Verbindungen besonders leicht möglich

Im Folgenden werden anhand einiger Ausführungsbeispiele Möglichkeiten für eine Durchführung des erfindungsgemäßen Verfahrens beschrieben. Es handelt sich dabei um praktisch erprobte Ausführungsbeispiele.

Die Ausführungsbeispiele sind in einer großen Beschichtungskammer durchgeführt worden, die sich besonders sinnvoll für eine hochskalierte Durchführung von Beschichtungen eignet. Die zu beschichtenden Substrate können durch diese Beschichtungskammer gedreht und bewegt werden, etwa mit einer Zweifachrotation. Der Durchmesser des Substrathalters betrug bei der Durchführung der Ausführungsbeispiele 600 mm.

Auf Grund der Beweglichkeit der Substrate war der Abstand des Substrates vom Target variabel. Der minimale Abstand lag dabei bei 200 mm, der Abstand betrug aber auch bis zu etwa 500 mm. Die Beweglichkeit der Substrate lässt sich natürlich für eine Serienfertigung ebenfalls gut nutzen.

Auf Grund der relativ hohen Abstände der Substrate von der Kathode kann sichergestellt werden, dass die Substrate sich außerhalb der Entladungszone des Targets befinden. Dadurch wird zuverlässig vermieden, dass die Substrate in die Entladungszone des Targets geraten, in der häufig eine hohe Plasmadichte herrscht, die sonst für ein Plasma unterstütztes CVD-Verfahren genutzt wird. Dieser Effekt wäre hier aber gerade bei den zu erzeugenden besonders harten Schichten weniger erwünscht. Bei der Konzeption der Ausführungsbeispiele unterliegen die Substrate vielmehr dem Sputterteilchenstrom vom Target, der aus ausgestäubtem Kohlenstoff und Wasserstoff besteht.

In einem ersten Beispiel erfolgt die Abscheidung einer metallfreien Kohlenstoffschicht in einer Gleichstrom-Magnetron-Sputteranlage mit vier Sputterkathoden. Es wird mit unbalancierten Magnetrons gearbeitet. Als Substrate dienen Flachproben aus Kugellagerstahl 100 Cr6 sowie dünne, etwa 0,2 mm messende Siliziumscheiben, ferner HSS-Spiralbohrer und andere metallische Substrate mit komplexen Geometrien. Die Substrate werden auf Standard-Substrathaltern für Mehrfachrotationen (2-fach oder 3-fach) befestigt und rotieren während des gesamten Beschichtungsprozesses.

Es werden insgesamt vier Targets eingesetzt, nämlich zwei aus Graphit und zwei aus Titan. Letztere dienen zur Herstellung einer metallischen Haftvermittlerschicht, die unterhalb der metallfreien Kohlenstoffschicht angeordnet werden soll.

Der Beschichtungsprozess lässt sich in vier Abschnitte unterteilen: in einem ersten Abschnitt wird das Substrat durch Ionenätzen (Ar⁺) gereinigt, wobei die Targets durch eine Blende, den sogenannten Shutter, abgedeckt sind. In einem zweiten Schritt wird dieser Shutter vor den beiden Titan-Targets geöffnet, während die beiden Graphit-Targets abgedeckt bleiben. Es wird die metallische Haftvermittlerschicht aus Titan durch nichtreaktives Sputtern des Titans mit Argon aufgebracht.

In einem dritten Abschnitt wird in den reaktiven Sputterprozess übergeleitet. Dabei wird zunächst langsam das Reaktivgas C₂H₂ zum Sputtergas dazugegeben und der C₂H₂-Gasfluss in einer Rampe bis zum festgelegten Endwert gesteigert. Die Titan-Targets werden abgeschaltet und die Graphit-Targets durch Öffnen der entsprechenden Shutter nehmen ihre Tätigkeit auf.

In einem vierten Schritt wird die metallfreie Kohlenstoffschicht in Form einer DLC- (Diamond like Carbon) Schicht mit einem konstanten C₂H₂-Fluss bei einer konstanten Gleichstrom-Bias-Spannung von minus 300 Volt abgeschieden. In einem praktischen Versuch beträgt die Abscheiderate 0,8 µm pro Stunde und die erreichte Schichtdicke 2,5 µm.

Die Schichtzusammensetzung kann mittels Sekundärionenmassenspektroskopie (SIMS) und die Struktur mittels Raman-Spektroskopie analysiert werden. Zur Charakterisierung der mechanischen und tribologischen Eigenschaften sind die Härte und der abrasive Verschleiß und auch die Haftung interessant. Die Härte kann mit einem Indentor-Verfahren, die Verschleißwerte mit einem Kalotten (Calo)-Tester und die Haftung mittels eines Rockwell-Eindruck-Testes sowie mittels Scretch-Testen bestimmt werden.

Eine Versuchsauswertung zeigt, dass sowohl die Zusammensetzung der Schichten als auch die Verschleiß- und Härtewerte als auch die Haftung der erfindungsgemäß erzeugten Schicht praktisch identisch derjenigen ist, die bei einer herkömmlich mittels Hochfrequenzverfahren abgeschiedenen DLC-Schicht erreicht werden konnte. Trotz der deutlich vorteilhafteren und einfacheren Herstellungsmöglichkeiten zeigt sich also keinerlei Qualitätsnachteil bei der Schicht.

Die Rockwellhärte (HRC) der Substrate ist sowohl beim herkömmlichen als auch beim erfindungsgemäßen Verfahren gegenüber dem Zustand vor den Beschichtungen (HRC ungefähr 62) nahezu unverändert. Dies zeigt, dass die Substrattemperaturen bei dem herkömmlichen und bei dem erfindungsgemäßen Verfahren jeweils unter 200 °C bleiben.

Bei einem **zweiten Beispiel** erfolgt die Schichtabscheidung ebenfalls in einer Gleichstrom-Magnetron-Sputter-Anlage mit vier Sputterkathoden. Es wird wiederum mit unbalancierten Magnetrons gearbeitet. Zwei Targets bestehen wiederum aus Graphit, die beiden anderen Targets aus Niob (Nb). Die Substrate sind die gleichen wie im ersten Beispiel.

Der Beschichtungsprozess läuft wiederum in vier Abschnitten ab. Zunächst wird eine Substratreinigung durch Ionenätzen (Ar⁺) durchgeführt, wobei die Targets durch eine Blende (Shutter) abgedeckt sind. Als zweites werden die Shutter vor den Niob-Targets geöffnet und die metallische Haftvermittlerschicht (Nb) durch nichtreaktives Sputtern von Niob mit Argon aufgebracht. Als drittes wird in den reaktiven Sputter-Prozess mittels der beiden Graphit-Targets übergeleitet, und zwar durch langsame Zugabe des Reaktivgases C₃H₈ zum Sputtergas und durch Abschalten der Niob-Targets. Dabei wird der C₃H₈-Gasfluss in einer Rampe bis zum festgelegten Endwert gesteigert. Schließlich wird die Kohlenstoffschicht wiederum als DLC-Schicht mit einem konstanten C₃H₈-Fluss bei einer konstanten Gleichstrom-Bias-Spannung von minus 200 Volt abgeschieden. Die Abscheiderate beträgt bei diesem Versuch 1,4 µm pro Stunde und die erreichte Schichtdicke 3 µm.

Eine Analyse der Schichten erbringt in einem Versuch die gleichen Ergebnisse wie beim ersten Beispiel.

In einem **dritten Beispiel** werden jetzt im Gegensatz zu den beiden vorgehenden Beispielen Flachproben aus verschiedenen Stahlsorten beschichtet. Dabei wird hier auf die Rotation verzichtet. Mit einer Substratanordnung direkt gegenüber einem Graphit-Target wird eine um etwa den Faktor 3 höhere Beschichtungsrate erreicht.

Zunächst erfolgt vor einem Titantarget die Abscheidung der metallischen Zwischenschicht. Anschließend werden die Substrate vor ein Graphit-Target geschwenkt und verbleiben dann in dieser Position. Dann werden, wie in den anderen Beispielen, die Schritte des Überleitens in den reaktiven Sputter-Prozess und der Abscheidung der Kohlenstoffschicht durchgeführt. Dabei wird als Kohlenstoffträger in diesem Beispiel Acetylen genutzt.

Die Abscheiderate beträgt 2,3 µm pro Stunde, die erreichte Schichtdicke 5 µm. Die Rockwellhärten (HRC) der Substrate nach den Beschichtungen sind auch bei einem Vergleich dieses erfindungsgemäßen Beispiels mit einem herkömmlichen Verfahren jeweils gegenüber dem Zustand vor den Beschichtungen mit HRC ungefähr 62 nahezu unverändert. Auch hier sind die Substrattemperaturen demnach unter 200 °C geblieben.

In der folgenden Tabelle sind einige der bei den tatsächlich durchgeführten Beispielen festgestellten Ergebnisse zusammengestellt.

| Schicht | Schichtdicke / µm | Metall-Haftvermittler | Wasserstoff-Gehalt / Atom-% | Härte / GPa | Abrasivverschleiß (relative Einheiten) | Haftungs-Klasse |
|---|---|---|---|---|---|---|
| HF-DLC (Referenz) | 3,0 | Ti | 15 | 31 | 0,5-0,7 | 1 |
| DLC-Schicht - Beispiel 1 | 2,7 | Ti | 14 | 32 | 0,6-0,8 | 1 |
| DLC-Schicht - Beispiel 2 | 3,0 | Nb | 15 | 30 | 0,5-0,7 | 1-2 |
| DLC-Schicht - Beispiel 3 | 5,0 | Ti | 13 | 36 | 0,6-0,8 | 1-2 |

## Patentansprüche

1. Verfahren zur Abscheidung von metallfreien amorphen wasserstoffhaltigen Kohlenstoffschichten auf Substraten,
**dadurch gekennzeichnet,**
**dass** es sich bei der Kohlenstoffschicht um eine diamond like carbon (DLC)-Schicht handelt,
**dass** von Targets auf die Substrate gesputtert oder mittels Bogenverdampfung abgeschieden wird,
**dass** die Targets mit einer negativen Gleichspannung vorgespannt werden,
**dass** die Abscheidung in Gegenwart einen Kohlenwasserstoffreaktivgases erfolgt.
**dass** als Target ein reines Kohlenstoff-Target eingesetzt wird,
**dass** das Substrat mit einer negativen Spannung vorgespannt wird,
**dass** eine Ionenstromdichte von mindestens 1 mA/cm² am Substrat erreicht
wird, und
**dass** die Abscheidung in Gegenwart eines Kohlenwasserstoffreaktivgases erfolgt.

2. Verfahren nach Anspruch 1,
**dadurch gekennzeichnet,**
**dass** der Abstand des Substrats vom Target größer ist als die Entladungszone des Targets.

3. Verfahren nach einem der Ansprüche 1 oder 2,
**dadurch gekennzeichnet,**
**dass** der Abstand des Substrates vom Target größer ist als 50 mm, insbesondere größer als 100 mm, bevorzugt größer als 200 mm.

4. Verfahren nach einem der Ansprüche 1 bis 3,
**dadurch gekennzeichnet,**
**dass** als Target ein Graphit-Target eingesetzt wird.

5. Verfahren nach einem der Ansprüche 1 bis 3,
**dadurch gekennzeichnet,**
**dass** als Target ein Glaskohlenstoff-Target eingesetzt wird.

6. Verfahren nach einem der vorstehenden Ansprüche,
**dadurch gekennzeichnet,**
**dass** mehrere Targets eingesetzt werden.

7. Verfahren nach Anspruch 6,
**dadurch gekennzeichnet,**
**dass** unterschiedliche, durch Blenden abtrennbare Targets eingesetzt werden, die zu zeitlich unterschiedlichen Abschnitten freigegeben werden und eine Doppel- beziehungsweise Multilagenbeschichtung des Substrates herbeiführen.

8. Verfahren nach Anspruch 7,
**dadurch gekennzeichnet,**
**dass** mindestens eines der weiteren Targets ein metallisches Target ist.

9. Verfahren nach Anspruch 7 oder, 8,
**dadurch gekennzeichnet,**
**dass** dabei eine Zwischenschicht zur Haftverbesserung aus Metallen, Metallnitriden, Metallcarbiden, Metallcarbonitriden oder Mehrlagenanordnungen mit diesen Komponenten abgeschieden wird, bevorzugt mit einer Dicke zwischen 0,02 µm und 2 µm.

10. Verfahren nach einem der Ansprüche 7 bis 9,
**dadurch gekennzeichnet,**
**dass** eine Deckschicht aus Kohlenstoff, Wasserstoff und/oder Stickstoff mit Metallverunreinigungen von weniger als 0,1 % abgeschieden wird.

11. Verfahren nach einem der vorstehenden Ansprüche,
**dadurch gekennzeichnet,**
**dass** das Substrat mit einer negativen Gleichspannung vorgespannt wird.

12. Verfahren nach einem der vorstehenden Ansprüche,
**dadurch gekennzeichnet,**
**dass** das Substrat mit einer Mittelfrequenzspannung zwischen 30 und 300 kHz angeregt wird.

13. Verfahren nach einem der vorstehenden Ansprüche,
**dadurch gekennzeichnet,**
**dass** die hohe Ionenstromdichte am Substrat **dadurch** erzielt wird, dass in der unbalancierten Magnetronbetriebsart gearbeitet wird.

14. Verfahren nach einem der vorstehenden Ansprüche,
**dadurch gekennzeichnet,**
**dass** als Reaktivgas eine Mischung aus Edelgasen und Kohlenwasserstoffgasen und/oder Kohlenwasserstoffdämpfen eingesetzt wird.

15. Verfahren nach Anspruch 14,
**dadurch gekennzeichnet,**
**dass** als Reaktivgas eine Mischung aus Argon und Acetylen eingesetzt wird.

16. Verfahren nach einem der vorstehenden Ansprüche,
**dadurch gekennzeichnet,**
**dass** das Reaktivgas während des Beschichtungsvorganges mit zusätzlichen gas- oder dampfförmigen Verbindungen sowie mit Stickstoff und/oder Sauerstoff gemischt oder durch Stickstoff ersetzt wird.

17. Verfahren nach Anspruch 16,
**dadurch gekennzeichnet,**
**dass** die zusätzlichen gas- oder dampfförmigen Verbindungen Silizium enthalten.

18. Verfahren nach Anspruch 16 oder 17,
**dadurch gekennzeichnet,**
**dass** die zusätzlichen gas- oder dampfförmigen Verbindungen Tetramethylsilan (TMS) enthalten.

19. Verfahren nach einem der Ansprüche 16 bis 18,
**dadurch gekennzeichnet,**
**dass** die zusätzlichen gas- oder dampfförmigen Verbindungen Hexamethyldisiloxan (HMDSO) enthalten.

## Claims

1. Method for depositing metal-free amorphous hydrogenous carbon layers on substrates,
**characterised in**
**that** the carbon layer is a diamond-like carbon (DLC) layer,
**that** the substrates are sputtered from targets or deposition takes place by means of arc evaporation,
**that** the targets are biased by a negative d.c. voltage,
**that** a pure carbon target is used as the target,
**that** the substrate is biased by a negative voltage,
**that** an ion current density of at least 1 mA/cm² is attained at the substrate, and
**that** the deposition takes place in the presence of a hydrocarbon reactive gas.

2. Method according to Claim 1,
**characterised in**
**that** the spacing of the substrate from the target is greater than the discharge zone of the target.

3. Method according to either of Claims 1 and 2,
**characterised in**
**that** the spacing of the substrate from the target is greater than 50 mm, in particular greater than 100 mm, preferably greater than 200 mm.

4. Method according to any one of Claims 1 to 3,
**characterised in**
**that** a graphite target is used as the target.

5. Method according to any one of Claims 1 to 3,
**characterised in**
**that** a glass-like carbon target is used as the target.

6. Method according to any one of the preceding Claims,
**characterised in**
**that** a plurality of targets are used.

7. Method according to Claim 6,
**characterised in**
**that** different targets, which can be separated by screens, are used, these being freed at intervals which differ in time and giving rise to a double- or multi-layer coating of the substrate.

8. Method according to Claim 7,
**characterised in**
**that** at least one of the further targets is a metallic target.

9. Method according to Claim 7 or 8,
**characterised in**
**that** there is deposited an intermediate layer for improving adhesion which consists of metals, metal nitrides, metal carbides, metal carbon nitrides or multi-layer arrangements with these components, preferably with a thickness of between 0.02 µm and 2 µm.

10. Method according to any one of Claims 7 to 9,
**characterised in**
**that** a covering layer which consists of carbon, hydrogen and/or nitrogen with metal impurities of less than 0.1% is deposited.

11. Method according to any one of the preceding Claims,
**characterised in**
**that** the substrate is biased by a negative d.c. voltage.

12. Method according to any one of the preceding Claims,
**characterised in**
**that** the substrate is excited by a medium frequency voltage of between 30 and 300 kHz.

13. Method according to any one of the preceding Claims,
**characterised in**
**that** the high ion current density at the substrate is attained by working in the unbalanced magnetron mode of operation.

14. Method according to any one of the preceding Claims,
**characterised in**
**that** a mixture of noble gases and hydrocarbon gases and/or hydrocarbon vapours is used as the reactive gas.

15. Method according to Claim 14,
**characterised in**
**that** a mixture of argon and acetylene is used as the reactive gas.

16. Method according to any one of the preceding Claims,
**characterised in**
**that** during the coating process the reactive gas is mixed with additional gaseous or vaporous compounds as well as with nitrogen and/or oxygen or is replaced by nitrogen.

17. Method according to Claim 16,
**characterised in**
**that** the additional gaseous or vaporous compounds contain silicon.

18. Method according to Claim 16 or 17,
**characterised in**
**that** the additional gaseous or vaporous compounds contain tetramethylsilane (TMS).

19. Method according to any one of Claims 16 to 18,
**characterised in**
**that** the additional gaseous or vaporous compounds contain hexamethyldisiloxane (HMDSO).

## Revendications

1. Procédé pour déposer des couches de carbone hydrogénées, amorphes, exemptes de métal, sur des substrats, **caractérisé en ce**
**que** la couche de carbone est une couche de diamond like carbon (DLC),
**qu'**une pulvérisation ou un dépôt par vaporisation à l'arc est effectué sur les substrats à partir de cibles,
**que** les cibles sont préalablement mises sous une tension continue, négative,
**que** l'on utilise, en tant que cible, une cible de carbone pur,
**que** le substrat est préalablement soumis à une tension négative,
**qu'**une densité de flux ionique d'au moins 1 mA / cm2 est atteinte sur le substrat, et
**que** le dépôt a lieu en présence d'un gaz réactif au carbure d'hydrogène.

2. Procédé selon la revendication 1, **caractérisé en ce que** la distance entre le substrat et la cible est plus grande que la zone de décharge de la cible.

3. Procédé selon revendication 1 ou 2, **caractérisé en ce que** la distance entre le substrat et la cible est supérieure à 100 mm, de préférence supérieure à 200 mm.

4. Procédé selon l'une des revendications 1 à 3, **caractérisé en ce que** l'on utilise en tant que cible une cible de graphite.

5. Procédé selon l'une des revendications 1 à 3, **caractérisé en ce que** l'on utilise, en tant que cible, une cible de carbone vitreux.

6. Procédé selon l'une des revendications précédentes, **caractérisé en ce que** l'on utilise plusieurs cibles.

7. Procédé selon la revendication 6, **caractérisé en ce que** l'on utilise différentes cibles, qui, pouvant être séparées des écrans, sont dégagées par sections changeant au cours du temps, et qui donnent un revêtement du substrat à deux couches ou plusieurs couches.

8. Procédé selon la revendication 7, **caractérisé en ce que** l'une des autres cibles au moins est une cible de métal.

9. Procédé selon revendication 7 ou 8, **caractérisé en ce que**, ce faisant, pour améliorer l'adhérence, une couche intermédiaire en métaux, nitrures métalliques, carbures métalliques, carbonitrures métalliques ou des agencements à plusieurs couches sont déposées avec ces composants, de préférence avec une épaisseur située entre 0,02 µm et 2 µm.

10. Procédé selon l'une des revendications 7 à 9, **caractérisé en ce qu'**est déposée une couche de recouvrement en carbone, hydrogène et / ou en azote, avec des impuretés métalliques à moins de 0,1 %.

11. Procédé selon l'une des revendications précédentes, **caractérisé en ce que** le substrat est préalablement soumis à une tension continue négative.

12. Procédé selon l'une des revendications précédentes, **caractérisé en ce que** le substrat est excité avec une tension à moyenne fréquence située entre 30 et 300 kHz.

13. Procédé selon l'une des revendications précédentes, **caractérisé en ce que** la densité élevée du flux ionique est obtenue en procédant selon le mode d'exploitation au magnétron non équilibré.

14. Procédé selon l'une des revendications précédentes, **caractérisé en ce que** l'on utilise en tant que gaz réactif un mélange de gaz nobles et d'hydrocarbures à l'état gazeux et / ou des vapeurs d'hydrocarbure.

15. Procédé selon la revendication 14, **caractérisé en ce que** l'on utilise en tant que gaz réactif un mélange d'argon et d'acétylène.

16. Procédé selon l'une des revendications précédentes, **caractérisé en ce que** le gaz réactif, pendant le processus de revêtement, est mélangé avec des combinaisons à l'état gazeux ou à l'état de vapeur, ainsi qu'avec de l'azote et / ou de l'oxygène, ou qu'il est remplacé par de l'azote.

17. Procédé selon la revendication 16, **caractérisé en ce que** les combinaisons supplémentaires à l'état gazeux ou à l'état de vapeur contiennent du silicium.

18. Procédé selon revendication 16 ou 17, **caractérisé en ce que** les combinaisons supplémentaires à l'état gazeux ou à l'état de vapeur contiennent du silane tétra-méthyle (TMS).

19. Procédé selon l'une des revendications 16 à 18, **caractérisé en ce que** les combinaisons supplémentaires à l'état gazeux ou à l'état de vapeur contiennent de l'héxaméthyldisiloxane (HMDSO).
